Europäisches Patentamt

(19) European Patent Office

Office européen des brevets

(11) Numéro de publication: **0 053 214 B1**

# (12) FASCICULE DE BREVET EUROPEEN

(45) Date de publication du fascicule du brevet:
26.08.87

(21) Numéro de dépôt: **80430027.5**

(22) Date de dépôt: **28.11.80**

(51) Int. Cl.⁴: **H 03 K 5/01,** H 04 L 7/00, H 04 L 25/20

(54) **Système de distribution de signaux numériques.**

(43) Date de publication de la demande:
09.06.82 Bulletin 82/23

(45) Mention de la délivrance du brevet:
26.08.87 Bulletin 87/35

(84) Etats contractants désignés:
**DE FR GB**

(56) Documents cités:
DE - A - 2 027 515
DE - A - 2 429 827
DE - B - 1 292 165
FR - A - 1 400 733
FR - A - 2 299 767
US - A - 3 430 070
US - A - 3 751 591

(73) Titulaire: **International Business Machines Corporation, Old Orchard Road, Armonk, N.Y. 10504 (US)**

(84) Etats contractants désignés: **DE GB**

(73) Titulaire: **Compagnie IBM FRANCE, 5 Place Vendôme, F-75000 Paris 1er (FR)**

(84) Etats contractants désignés: **FR**

(72) Inventeur: **Froment, Jean-Claude, Avenue Bellevue, F-06270 Villeneuve-Loubet (FR)**
Inventeur: **Marijon, Jean-Louis 1, rue du Professeur Villemin, Résidence de l'Host No. 201, F-33170 Gradignan (FR)**
Inventeur: **Orengo, Gérard, Les Hortensias B Chemin Ames du Purgatoire, F-06600 Antibes (FR)**
Inventeur: **Verhaeghe, Michel, 30, Le Suve, F-06140 Vence (FR)**

(74) Mandataire: **Lattard, Nicole, Compagnie IBM France Département de Propriété Intellectuelle, F-06610 La Gaude (FR)**

## Description

Domaine Technique

La présente invention concerne un système de distribution de signaux numériques entre des points éloignés d'une machine ou entre plusieurs machines, permettant de réduire au minimum la distorsion de la largeur des signaux, c'est-à-dire permettant de maintenir constant le rapport cyclique des signaux.

Dans les machines actuelles traitant des données numériques telles que des unités centrales de traitement, les contrôleurs de communication ou les centraux téléphoniques, etc., des signaux d'horloge de fréquence élevés sont nécessaires pour synchroniser le fonctionnement des différents circuits composant la machine. En conséquence, les signaux d'horloge doivent être transportés en plusieurs points et il est impératif pour limiter les causes d'erreurs qu'il n'y ait pas de distorsion dans la largeur des signaux, c'est-à-dire que le rapport cyclique des signaux d'horloge soit maintenu constant au cours de la distribution.

Art Antérieur

Actuellement, les problèmes de réduction de la distorsion peuvent être résolus en prévoyant des circuits de réglage qui permettent d'ajuster les écarts introduits lors de la transmission des signaux.

Par exemple, l'article paru dans l'IBM Technical Disclosure Bulletin, volume 21, No. 7, de décembre 1978, pages 2998 et 2999, décrit un dispositif permettant de compenser automatiquement la distorsion dans les circuits d'horloge intégrés. Ce dispositif permet d'ajuster automatiquement les signaux d'horloge générés à partir d'un oscillateur principal lorsque tous les circuits d'horloge se trouvent sur une même microplaquette. Pour ce faire, il nécessite des moyens pour générer des signaux de calibration qui suivant les caractéristiques de la microplaquette agissent par l'intermédiaire d'un circuit de réglage pour ajuster les écarts de phase entre les différents signaux d'horloge dérivés du signal de base fourni par l'oscillateur. Cette technique permet de réduire la distorsion entre les différents signaux générés à partir de l'oscillateur principal mais ne résout pas le problème posé par la distribution de ces signaux en des points éloignés.

Le brevet des US-A 3 751 591 concerne un système de distribution de signaux d'horloge conçu de telle façon que les réflexions à l'intérieur du système font que tous les points dans le système sont à la même tension en même temps lorsque le système reçoit les signaux d'un circuit d'attaque. Ceci impose des contraintes de temps de montée, d'impédance, etc., ce qui limite ses applications.

Résumé de l'Invention

Un objet de la présente invention est de réaliser un système de distribution de signaux numériques qui ne nécessite pas de circuits supplémentaires pour diminuer la distorsion de la largeur des signaux.

Un autre objet de la présente invention est de réaliser un tel système de distribution particulièrement bien adapté à la distribution des signaux d'horloge dans une machine.

Un autre objet de la présente invention est de réaliser un système de distribution de signaux qui présente une grande souplesse d'utilisation.

Le système de distribution de signaux numériques fournis par une source (1) à des points éloignés de cette source connu du brevet US-A 3 751 591 comprend en chaque point un dispositif de distribution (2 ou 3) pourvu d'un récepteur (4 ou 6) constitué d'un premier circuit différentiel. Le système suivant la présente invention est caractérisé en ce que les signaux numériques sont fournis en forme complémentaire (H, H̄) sur deux conducteurs (8, 9), que le dispositif de distribution (2 ou 3) comprend au moins un circuit d'attaque constitué par un second circuit différentiel ayant des caractéristiques de commutation identiques à celles du premier circuit, chacun desdits premier et second circuits différentiels ayant deux entrées complémentaires (I, Ī) et deux sorties complémentaires (Q, Q̄), les signaux obtenus aux sorties Q, Q̄ ayant la même polarité que ceux appliqués aux entrées I, Ī respectivement et les signaux obtenus aux sorties de dénomination commune des deux circuits différentiels ayant la même polarité si des signaux de même polarité sont appliqués aux entrées de dénomination commune des deux circuits, et que les sorties Q, Q̄ du premier circuit différentiel sont connectées aux entrées Ī, I du second circuit différentiel respectivement (connexion dite croisée).

Afin d'améliorer la qualité des signaux à utiliser localement, c'est-à-dire qu'ils ne soient pas influencés par la charge de la liaison de transmission, on peut prévoir plusieurs circuits d'attaque dans le même dispositif l'un permettant d'assurer la transmission à un point éloigné et les autres permettant d'assurer la distribution locale pour l'utilisation locale. Les circuits d'attaque dans ce cas sont ainsi connectés par une connexion croisée aux sorties du récepteur.

Brève description des figures

La figure 1 représente, de façon schématique, le principe de la présente invention.

La figure 2 représente un diagramme des temps montrant les avantages de la présente invention.

La figure 3 représente le schéma d'un module universel qui peut être utilisé pour l'alimentation en signaux numériques d'une machine.

La figure 4 représente le schéma d'un récepteur pouvant être utilisé dans les systèmes de distribution des figures 1 et 3.

La figure 5 représente le schéma d'un circuit d'attaque pouvant être utilisé dans les systèmes de distribution des figures 1 et 3.

Description détaillée de l'invention

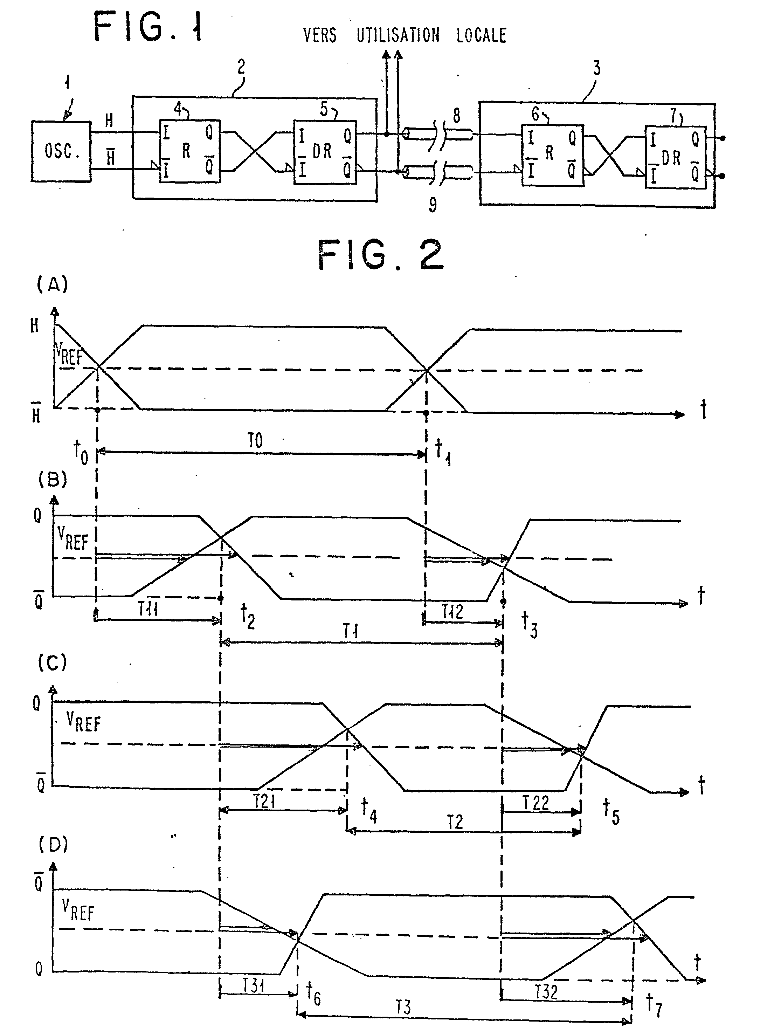

Sur la figure 1, est représentée une chaîne de transmission de signaux qui dans un mode de réalisation préféré sont des signaux d'horloge H et H̄ déphasés de 180°. Ces signaux peuvent être fournis par n'importe quel type d'oscillateur et de circuit associé fournissant des signaux d'horloge déphasés.

La chaîne de transmission comporte plusieurs dispositifs de distribution identiques, on en a représenté deux, 2 et 3 sur le dessin, ceci à titre d'exemple. Les dispositifs à l'intérieur de la machine sont reliés entre eux par une liaison qui a été représentée sous forme de câbles coaxiaux sur le dessin.

Chaque dispositif comprend un récepteur R et un circuit d'attaque DR, récepteur 4 et circuit d'attaque 5 dans le dispositif 2 et récepteur 6 et circuit d'attaque 7 dans le module 3. Chacun des circuits R et DR comporte deux entrées complémentaires I et $\overline{I}$ et deux sorties complémentaires Q et $\overline{Q}$. Au cours de la description pour désigner les entrées I et $\overline{I}$ ou les sorties Q et $\overline{Q}$ d'un circuit particulier on ajoutera à ces références un suffixe, le numéro de référence du circuit par exemple $I_4$ et $\overline{Q}_4$ pour désigner l'entrée I et la sortie $\overline{Q}$ du circuit 4. Les entrées et sorties complémentaires $\overline{I}$ et $\overline{Q}$ portent aussi le signe distinctif $\diagdown$.

Les deux dispositifs sont connectés par l'intermédiaire de câbles 8 et 9 directement ou par l'intermédiaire d'autres dispositifs identiques.

Les circuits R et DR sont des circuits totalement différentiels, c'est-à-dire, les signaux sur leurs entrées I et $\overline{I}$ sont complémentaires de même que les signaux sur leurs sorties Q et $\overline{Q}$. Les signaux sur les sorties Q et $\overline{Q}$ dépendent de la différence des signaux sur les entrées I et $\overline{I}$ de telle sorte que le signal sur la sortie Q est en phase avec la différence entre les signaux sur les entrées I et $\overline{I}$ et le signal sur la sortie $\overline{Q}$ est en phase avec la différence entre les signaux sur les entrées $\overline{I}$ et I. La commutation des signaux sur les sorties Q et $\overline{Q}$ se produit avec un certain retard par rapport à la commutation des signaux sur les entrées I et $\overline{I}$ à cause des imperfections des circuits. Il faut noter, que en régime établi pour chaque dispositif, la sortie Q est en phase avec l'entrée I, et la sortie $\overline{Q}$ est en phase avec l'entrée $\overline{I}$. Dans la suite de la description les entrée et sortie I et Q seront dites «vraies» et les entrée et sortie $\overline{I}$ et $\overline{Q}$ seront dites «complémentaires». Des exemples de circuits pouvant être utilisés seront décrits par la suite. La fonction du circuit récepteur R est de recevoir les signaux et de les mettre en forme et la fonction du circuit DR est de transmettre les signaux vers un autre dispositif éloigné ou de les fournir pour l'utilisation locale.

Comme on peut le voir sur la figure, dans un dispositif la sortie vraie Q du récepteur R est connectée à l'entrée complémentaire $\overline{I}$ du circuit d'attaque DR et la sortie complémentaire $\overline{Q}$ est connectée à l'entrée I du circuit d'attaque DR, ceci pour réduire la distorsion de la largeur des signaux comme on le montrera par la suite en référence à la figure 2.

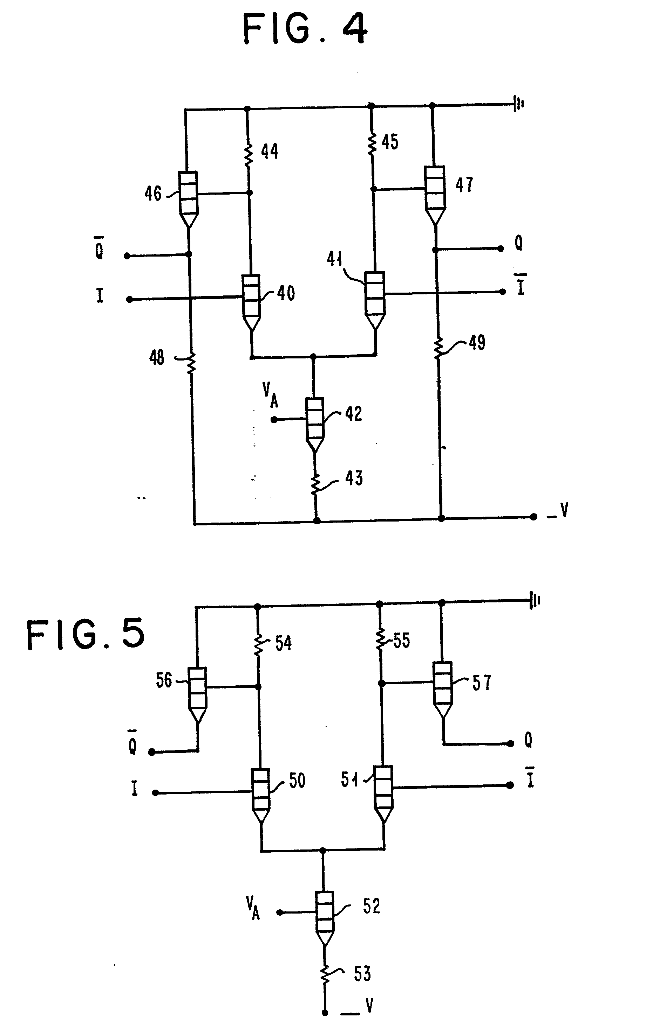

Sur la figure 2 sont représentées les différentes formes d'onde qui sont obtenues avec des circuits récepteur et d'attaque par exemple du type à émetteurs couplés tels qu'ils seront décrits ultérieurement en référence aux figures 4 et 5.

Les signaux d'horloge complémentaires sont représentés à titre d'exemple par les formes d'onde A. Ce sont les signaux qui sont appliqués aux entrées I et $\overline{I}$ du récepteur R du premier dispositif par exemple. Les fronts arrière et avant de ces signaux se croisent aux temps $t_0$ et $t_1$, l'intervalle To séparant ces deux instants étant égal à la largeur de l'impulsion qui doit être conservée.

La forme d'onde B représent à titre d'exemple les signaux Q et $\overline{Q}$ à la sortie du récepteur et à l'entrée du circuit d'attaque. Les récepteur et circuit d'attaque sont généralement des circuits à transistors qui fonctionnent en mode commutation. Les retards des signaux de sortie sont définis par les temps auxquels les signaux de sortie coupent une tension de référence $V_{REF}$. Le front de descente de $\overline{Q}$ coupe la tension de référence au bout d'un temps $T_B\overline{Q}$ par rapport à $t_0$ et le front de montée de Q coupe la tension de référence au bout d'un temps $T_CQ$.

Le front de descente de Q coupe la tension de référence au bout d'un temps $T_BQ$ par rapport à $t_1$ et le front de montée de $\overline{Q}$ coupe la tension de référence au bout d'un temps $T_C\overline{Q}$. De même les temps de montée $T_M$ et de descente $T_D$ des signaux de sortie Q et $\overline{Q}$ ne sont généralement pas les mêmes.

On prendra, par la suite, des temps de commutation, très différents les uns des autres, afin de montrer sur un diagramme des temps des différents signaux, comment fonctionne l'invention proposée.

| | | | |
|---|---|---|---|
| $T_CQ$ | = 4 unités | $T_C\overline{Q}$ | = 5 unités |
| $T_BQ$ | = 7 unités | $T_B\overline{Q}$ | = 3 unités |
| $T_MQ$ | = 2 unités | $T_M\overline{Q}$ | = 6 unités |
| $T_DQ$ | = 4 unités | $T_M\overline{Q}$ | = 8 unités |

Comme on peut le voir sur la figure 2, les deux signaux Q et $\overline{Q}$ à la sortie du récepteur représentés en B ont des fronts avant et arrière qui se coupent en $t_2$ et $t_3$, ce qui définit une largeur d'impulsion $T_1$.

Les circuits récepteur et d'attaque étant choisis du même type et de la même technologie, les paramètres ci-dessus sont les mêmes qu'il s'agisse d'un récepteur ou d'un circuit d'attaque.

En conséquence si les signaux représentés en B sur la figure 2, sont appliqués au circuit d'attaque par une connexion directe, c'est-à-dire en reliant d'une part la sortie Q du récepteur à l'entrée I du circuit d'attaque, et, d'autre part la sortie $\overline{Q}$ du récepteur à l'entrée $\overline{I}$ du circuit d'attaque, on obtiendrait sur les sorties Q et $\overline{Q}$ du circuit d'attaque, les signaux représentés en C dont les fronts avant et arrière se coupent en $t_4$ et $t_5$, instants qui définissent une largeur d'impulsion T2.

Par contre si on connecte le récepteur au circuit d'attaque par une connexion croisée conformément à la présente invention on obtient sur les sorties Q et $\overline{Q}$, les signaux représentés en D, dont les flancs avant et arrière se coupent aux instants $t_6$ et $t_7$ définissant une largeur d'impulsion T3.

Comme on peut le voir sur la figure 2, $t_2$ et $t_0$ sont distants de T11, $t_4$ et $t_2$ sont distants de T21 = T11.

$t_3$ et $t_1$ sont distants de T12 et $t_5$ et $t_3$ sont distants de T22 = T12. Compte tenu de la connexion croisée $t_6$ et $t_2$ sont distants de T31 = T12 et $t_7$ et $t_3$ sont distants de T32 = T11.

En conséquence:

T1 = T0+T12−T11
T3 = T1+T32−T31

ce qui donne:

T3 = T0.

Ce qui donne un écart de la largeur d'impulsion

T3−T0 = 0

Pour ce qui concerne la connexion directe on peut écrire:

T2 = T1−T21+T22

comme

T1 = T0+T12−T11

on obtient:

T2−T0 = 2 (T1−T0)

T1−T0 étant l'écart de la largeur d'impulsion dû au récepteur, on peut voir que, contrairement au cas précédent de la connexion croisée pour lequel l'écart était nul, le mode de connexion directe double l'écart initial T1−T0 des largeurs d'impulsion. Avec les paramètres pris à titre d'exemple on a T1−T0 = 2,4 unités et en conséquence la distorsion de largeur d'impulsion est égale à 4,8 unités.

Il est bien évident que ce résultat qui a été démontré géométriquement d'une façon simple, est obtenu dans tous les cas de figure et peut se démontrer mathématiquement.

Pour mettre en application ce principe, il est prévu un module universel intégré de faible dimension comportant un circuit récepteur et plusieurs circuits d'attaque. Ce module est placé dans la machine aux points où les signaux d'horloge sont nécessaires.

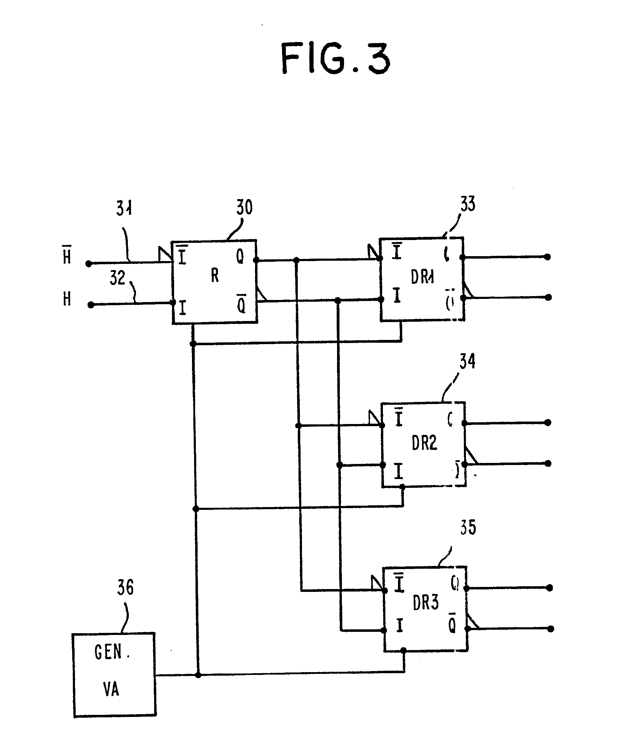

La configuration générale des circuits sur ce module va être décrite en référence à la figure 3. Il comprend un récepteur R, 30 qui reçoit sur ses entrées 31 et 32 les signaux à transmettre et utiliser localement H̄ et H. Trois circuits d'attaque sont prévus DR1, DR2 et DR3, 33, 34, 35 respectivement dont les entrées Ī sont connectées à la sortie Q du récepteur 30 et les entrées I sont connectées à la sortie Q̄. Un générateur 36 de tension fournit la tension de fonctionnement $V_A$ des différents circuits.

Les signaux sur les sorties Q et Q̄ du circuit d'attaque 33, peuvent être transmis vers un point éloigné de la machine au récepteur d'un autre module identique placé en ce point. Suivant l'éloignement la transmission peut se faire par des câbles coaxiaux ou des paires torsadées.

Les signaux aux sorties Q et Q̄ des circuits d'attaque 34 et 35 sont disponibles pour être utilisés localement dans des circuits situés sur la même carte que le module. En conséquence, ils ne sont pas influencés par la transmission à distance, comme ce pourrait être le cas avec le schéma de la figure 1.

Un autre avantage de cette configuration, est que les trois circuits d'attaque peuvent être tous identiques ou bien peuvent avoir des caractéristiques qui leur permettent de répondre à différents besoins, d'impédance ou d'adaptation de niveaux. Si, dans la machine, les signaux d'horloge doivent alimenter des circuits de technologie différente, il peut s'avérer nécessaire de fournir les niveaux adéquats pour les signaux d'horloge.

De plus on peut aussi prévoir un nombre plus ou moins grand de circuits d'attaque en fonction de l'impédance et de la configuration de la machine.

Sur la figure 4 est représenté le schéma d'un récepteur qui peut être utilisé dans les configurations des figures 1 ou 3.

Le récepteur est du type bien connu à transistors à émetteurs couplés. Il comprendra deux transistors 40 et 41 dont les bases constituent les entrées I et Ī. Les émetteurs sont reliés ensemble à une source de courant constituée par un transistor 42 dont le collecteur est connecté aux émetteurs communs et l'émetteur est connecté à une tension d'alimentation −V par une résistance 43. La conduction du transistor 42 est commandée par une tension $V_A$ appliquée à sa base.

Les collecteurs des transistors 40 et 41 sont connectés d'une part par des résistances 44 et 45 à une autre tension d'alimentation qui est égale à la masse dans le mode de réalisation représenté et d'autre part aux bases des transistors 46 et 47 montés en émetteur suiveur. Les émetteurs des transistors 46 et 47 sont reliés à la tension −V par des résistances 48 et 49 respectivement et leurs collecteurs sont reliés à la masse.

Les sorties Q et Q̄ du récepteur sont prises aux émetteurs des transistors 47 et 46 respectivement.

Le fonctionnement d'un tel circuit est très simple, on en rappellera ici brièvement le principe. Suivant les niveaux sur l'une et l'autre des entrées I et Ī, l'un ou l'autre des transistors 40 ou 41 conduit, l'autre étant bloqué. En conséquence, les niveaux sur les sorties Q̄ et Q seront les inverses de ceux sur les entrées I et Ī respectivement.

Conformément à l'invention, les circuits d'attaque ont la même configuration de base afin de réaliser la compensation des écarts de largeur d'impulsion, par les connexions croisées de la présente invention.

Un exemple de circuit d'attaque pouvant être utilisé pour mettre en œuvre la présente invention est représenté sur la figure 5. Comme on peut le voir, sa configuration est identique à celle de la figure 4 sauf que les résistances émetteurs des transistors émetteurs suiveurs ont été supprimées.

Il comporte deux transistors à émetteurs couplés 50 et 51 associés à une source de courant, transistor 52 et résistance 53. Les bases de 50 et 51 constituent les entrées I et Ī et seront donc connectées aux sorties Q̄ et Q du récepteur. Les collecteurs de 50 et 51 sont connectées par deux résistances 54 et 55 à la masse et sont aussi connectés aux bases des transistors émetteur-suiveur 56 et 57. Les collecteurs de 56 et 57 sont connectés à la masse et les sorties Q et Q̄ du circuit d'attaque sont prises aux émetteurs des transistors 57 et 56 respectivement.

Les sorties étant laissées flottantes dans le module la dissipation de puissance est diminuée si le circuit d'attaque n'est pas utilisé. De plus cela permet d'attacher aux sorties n'importe quel type de charge.

Ce module permet de rendre la distribution des signaux d'horloge ou autre type, à l'intérieur d'une machine très souple. En effet les différentes parties de la machine peuvent être alimentées en étoile à partir d'un point central ou elles peuvent être alimentées en série. On peut aussi combiner ces deux types d'alimentation. Il suffit de disposer les modules en fonction de la configuration de la machine aux points les mieux appropriés.

Le sens des connexions entre les modules de distribution n'a pas d'importance, elles peuvent être directes ou croisées, l'essentiel étant que les modules eux-mêmes aient été réalisés, comme représenté sur la figure 3.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Système de distribution de signaux numériques fournis par une source (1) à des points éloignés de cette source comprenant en chaque point un dispositif de distribution (2 ou 3) pourvu d'un récepteur (4 ou 6) constitué d'un premier circuit différentiel caractérisé en ce que les signaux numériques sont fournis en forme complémentaire (H, H̄) sur deux conducteurs (8, 9), que le dispositif de distribution (2 ou 3) comprend au moins un circuit d'attaque constitué par un second circuit différentiel ayant des caractéristiques de commutation identiques à celles du premier circuit, chacun desdits premier et second circuits différentiels ayant deux entrées complémentaires (I, Ī) et deux sorties complémentaires (Q, Q̄), les signaux obtenus aux sorties Q, Q̄ ayant la même polarité que ceux appliqués aux entrées I, Ī respectivement et les signaux obtenus aux sorties de dénomination commune des deux circuits différentiels ayant la même polarité si des signaux de même polarité sont appliqués aux entrées de dénomination commune des deux circuits, et que les sorties Q, Q̄ du premier circuit différentiel sont connectées aux entrées Ī, I du second circuit différentiel respectivement.

2. Système de distribution selon la revendication 1 caractérisé en ce que le circuit d'attaque fournit sur ses sorties Q, Q̄ les signaux d'une part à la partie de la machine située en ce point et d'autre part au récepteur d'un autre dispositif de distribution placé en un autre point, par l'intermédiaire d'une liaison électrique directe.

3. Système de distribution selon la revendication 1 caractérisé en ce que chaque dispositif de distribution comprend plusieurs circuits d'attaque (33, 34, 35) connectés au récepteur (30) l'un des circuits d'attaque fournissant sur ses sorties Q, Q̄ les signaux numériques au récepteur d'un dispositif de distribution placé en un point éloigné et les autres circuits d'attaque fournissant sur leurs sorties Q, Q̄ les signaux pour l'utilisation locale.

**Claims**

1. A system for distributing digital signals supplied by a source (1) to points remote therefrom, comprising at each point a distribution device (2 or 3) provided with a receiver (4 or 6) consisting of a first differential circuit, characterized in that said digital signals are generated in complementary form (H, H̄) over two conductors (8, 9); in that said distribution device (2 or 3) includes at least one driver consisting of a second differential circuit the switching characteristics of which are identical to those of said first circuit, each of said first and second differential circuits having two complementary inputs (I, Ī) and two complementary outputs (Q, Q̄), with the signals obtained at outputs Q, Q̄ having the same polarity as those applied to inputs I, Ī, respectively, and with the signals obtained at outputs bearing the same designations in both differential circuits having the same polarity if signals of the same polarity are applied to inputs bearing the same designations in both circuits; and in that outputs Q, Q̄ of said first differential circuit are connected to inputs Ī, I of said second differential circuit, respectively.

2. A distribution system according to claim 1, characterized in that the driver supplies on its outputs Q, Q̄ the signals to that portion of the machine which is located at that point and to the receiver of another distribution device located at another point, through a direct electrical connection.

3. A distribution system according to claim 1, characterized in that each distribution device includes several drivers (33, 34, 35) connected to the receiver (30), one of said drivers Q, Q̄ the digital signals intended for the receiver of a remote distribution device and the other drivers supplying on their outputs Q, Q̄ signals intended for local use.

**Patentansprüche**

1. System für die Verteilung digitaler Signale, die von einer Quelle (1) an von dieser Quelle entfernte Punkte abgegeben werden, mit einer Verteilvorrichtung an jedem Punkt (2 oder 3), versehen mit einem Empfänger (4 oder 6) aus einer ersten Differentialschaltung bestehend, dadurch gekennzeichnet, dass die digitalen Signale in komplementärer Form (H, H̄) auf zwei Leiter (8, 9) gegeben werden, dass die Verteilvorrichtung (2 oder 3) mindestens eine Ansteuerschaltung enthält, die aus einer zweiten Differentialschaltung mit gleichen Schaltmerkmalen wie die erste Schaltung besteht, während jede der beiden besagten Differentialschaltungen zwei komplementäre Eingänge (I, Ī) und zwei komplementäre Ausgänge (Q, Q̄) besitzt und die an den Ausgängen Q, Q̄ auftretenden Signale die gleiche Polung aufweisen wie die an den Eingängen I bzw. Ī angelegten, und die an den Ausgängen der gemeinsamen Bezeichnung der beiden Differentialschaltungen erhaltenen Signale die gleiche Polung aufweisen, wenn Signale gleicher Polung an die Eingänge gemeinsamer Bezeichnung der beiden Schaltungen gelegt werden, und die Ausgänge Q, Q̄ der ersten Differentialschaltung an die Eingänge I bzw. Ī der zweiten Differentialschaltung angeschlossen sind.

2. Verteilsystem gemäss Anspruch 1, dadurch gekennzeichnet, dass die Ansteuerschaltung an ihren Ausgängen Q, Q̄ die Signale einerseits an den an diesem Punkt gelegenen Teil der Maschine abgibt, und andererseits an den Empfänger einer anderen Verteilvorrichtung, die an einem anderen Punkt angeordnet ist, mit Hilfe einer direkten elektrischen Verbindung.

3. Verteilsystem gemäss Anspruch 1, dadurch gekennzeichnet, dass jede Verteilvorrichtung mehrere Ansteuerschaltungen (33, 34, 35) umfasst, die an den Empfänger (30) angeschlossen sind, wobei eine der Ansteuerschaltungen an ihren Ausgängen Q, Q̄ die digitalen Signale an den Empfänger einer Verteilvorrichtung abgibt, die an einem entfernten Punkt angeordnet ist, und die anderen Ansteuerschaltungen an ihren Ausgängen Q, Q̄ die Signale für die örtliche Verwendung abgeben.

# FIG. 1

VERS UTILISATION LOCALE

# FIG. 2

(A)

(B)

(C)

(D)

# FIG.3

0 053 214

# FIG. 4

# FIG. 5

11